# EUROPEAN PATENT SPECIFICATION

(11) **EP 3 954 183 B1**
(45) Date of publication and mention of the grant of the patent: **03.12.2025**
(21) Application number: 19923995.5
(22) Date of filing: 12.04.2019
(51) Int. Cl.: H05K 7/20, H01L 23/34, H01L 23/40, H01L 23/42

(54) **HEAT DISSIPATION**
WÄRMEABLEITUNG
DISSIPATION DE CHALEUR

(43) Date of publication of application: 16.02.2022
(73) Proprietor: Nokia Solutions and Networks Oy, 02610 Espoo (FI)
(72) Inventor: XU, Sheng, Hangzhou Zhejiang 310053 (CN); ZHU, Jianqin, Hangzhou Zhejiang 310053 (CN); HU, Xiongxiong, Hangzhou Zhejiang 310053 (CN)
(74) Representative: Swindell & Pearson Limited
(86) International application number: PCT/CN2019/082427
(87) International publication number: WO 2020/206675

(56) References cited:
- CN-A- 1 802 747
- CN-A- 102 893 390
- CN-A- 104 350 813
- CN-A- 104 968 728
- CN-U- 206 743 752
- US-A1- 2002 012 762
- US-A1- 2013 032 324
- US-A1- 2015 084 182
- US-B1- 6 349 032
- US-B2- 7 369 411

## Description

### TECHNOLOGICAL FIELD

Embodiments of the present invention relate to dissipating heat. Some relate to an apparatus for dissipating heat from a printed wiring board.

### BACKGROUND

Components on a printed wiring board may generate significant heat, but may be of a very small size. This may lead to an increase in temperature of the component which can affect its performance or cause it to fail. It is therefore common practice to use heat sinks to dissipate heat from a component on a printed wiring board. In some examples, a heat spreader is connected between a component and the heat sink to improve transfer of thermal energy from a component to the larger heat sink. It is beneficial to ensure good thermal conductivity between the component and the heat spreader and between the heat spreader and the heat sink during operation and use. The thermal interface material that is used to thermally interconnect the component and the heat spreader and the thermal interface material that is used to thermally interconnect the heat spreader and the heat sink, may to provide good thermal conductivity and also may absorb manufacturing tolerances, in-use strains caused by changes in temperature and/or physical vibrations or shocks. US 2013/0032324 A1 discloses an example of a heat sink mounted on a component on a printed circuit board.

### BRIEF SUMMARY

According to various, but not necessarily all, embodiments there is provided an apparatus comprising: a heat sink; a heat spreader; a printed wiring board; a resilient bias means positioned between the heat sink and the heat spreader; and at least one retainer configured to force the heat sink towards the heat spreader against the resilient bias means and configured to force the printed wiring board towards the heat spreader, wherein the heat sink comprises at least one protrusion, wherein the at least one protrusion extends at least into a respective aperture in the heat spreader.

In some but not necessarily all examples, at least one protrusion extends through a respective aperture in the heat spreader.

In some but not necessarily all examples, the at least one protrusion extends from the heat sink through the aperture in the heat spreader and does not abut the printed wiring board.

In some but not necessarily all examples, the at least one protrusion extends from the heat sink through the aperture in the heat spreader to abut the printed wiring board.

In some but not necessarily all examples, the resilient bias means is positioned by the protrusion, the resilient bias means surrounding the protrusion.

In some but not necessarily all examples, the heat sink comprises a recessed portion that receives and positions the resilient bias means.

In some but not necessarily all examples, the resilient bias means is a spring.

In some but not necessarily all examples, the at least one retainer fixes the printed wiring board to the heat sink.

In some but not necessarily all examples, the at least one retainer extends through an aperture in the heat spreader.

In some but not necessarily all examples, the retainer extends through an aperture in the printed wiring board.

In some but not necessarily all examples, the at least one retainer is a screw.

In some but not necessarily all examples, the apparatus comprises at least one component on the printed wiring board and comprising thermal interface material coupling the at least one component to the heat spreader and thermal interface material coupling the heat spreader to the heat sink.

In some but not necessarily all examples, the heat spreader comprises a three-dimensional contact region sized to match dimensions of the at least one component.

In some but not necessarily all examples, the apparatus comprises multiple components on the printed wiring board wherein each of the multiple components contacts the heat spreader via thermal interface material and wherein the heat spreader has a three-dimensional shape that conforms to at least height dimensions of the multiple components.

In some but not necessarily all examples, the heat sink and the heat spreader comprise inter-coupled features.

In some but not necessarily all examples, telecommunication equipment comprises the apparatus. The telecommunication equipment, in some examples, comprises a fan for forced air cooling.

According to various, but not necessarily all, embodiments there is provided examples as claimed in the appended claims.

### BRIEF DESCRIPTION

Some examples will now be described with reference to the accompanying drawings in which:
FIG. 1 shows an example of the subject matter described herein;
FIGS. 2A, 2B shows another example of the subject matter described herein;
FIG. 3 shows another example of the subject matter described herein;
FIG. 4 shows another example of the subject matter described herein;
FIG. 5 shows another example of the subject matter described herein;
FIGS. 6A, 6B, 6C shows another example t of the subject matter described herein;
FIGS. 7A, 7B shows another example of the subject matter described herein;
FIGS. 8A, 8B shows another example of the subject matter described herein;
FIG. 9 shows another example of the subject matter described herein;
FIG. 10 shows another example of the subject matter described herein;
FIG. 11 shows another example of the subject matter described herein;
FIG. 12 shows another example of the subject matter described herein;
FIGS. 13A, 13B, 13C shows another example of the subject matter described herein.

### DETAILED DESCRIPTION

The following figures illustrate an apparatus 10 comprising: a heat sink 20; a heat spreader 30; a resilient bias means 50 positioned between the heat sink 20 and the heat spreader 30 and at least one retainer 60 configured to force the heat sink 20 towards the heat spreader 30 against the resilient bias means 50 and configured to force the printed wiring board 40 towards the heat spreader 30.

Thermal interface material 80 may be used to form a thermally conducting interface between the heat spreader 30 and the heat sink 20 and, separately, between the heat spreader 30 and one or more components 70 of the printed wiring board 40. The neutral equilibrium that results between the compressive forces provided by the retainer 60 and the expansive forces provided by the resilient bias means 50 may mitigate the effects of manufacturing tolerances and/or differences in thermal expansion and/or vibration shocks. The forces generated between the heat spreader 30 and the heat sink 20 and between the heat spreader 30 and the component 70 are controlled by the interaction of the at least one retainer 60 and the resilient bias means 50. The thermal interface material 80 may therefore be configured for desired thermal conductivity between the component 70 and the heat spreader 30 and between the heat spreader 30 and the heat sink 20.

A heat sink 20 may be formed from a material with a high specific heat capacity and high thermal conductivity. The heat sink may, for example, be formed from copper or aluminum metal or alloys. The heat sink 20 loses heat via convection of a fluid, for example air, over its surface. The heat sink 20 may, for example, comprise fins that increase its surface area to increase the rate of heat loss from its surface. The heat sink 20 operates as a thermodynamic heat reservoir that transfers heat generated by the one or more components 70 on the printed wiring board 40.

A heat spreader 30 conducts heat from a heat source, such as one or more components 70 on the printed wiring board 40, to the heat sink 20. The heat spreader 30 is designed to reduce the higher heat-flux density at the interface between the heat spreader 30 and a component 70 of the printed wiring board 40 to a lower heat-flux density at the interface between the heat spreader 30 and the heat sink 20. The heat sink 20 further reduces the heat-flux density, which may for example, allow for air cooling.

In some, but not necessarily all examples, the heat sink 20 may be a material such as copper or aluminum alloy or a composite material. In some, but not necessarily all examples, the heat spreader 30 may comprise a vapor chamber. A vapor chamber comprises a volatile fluid which transfers heat by evaporation from an interface between the component 70 and the heat spreader 30 by evaporation to the interface between the heat spreader 30 and the heat sink 20 by condensation. The heat spreader 30 can for example be a metal heat spreader, a vapor chamber or a hybrid heat spreader combining a heat spreader base and a high thermal conductivity part.

The component 70 on the printed wiring board 40 may be a packaged component or a lidless component. If the component 70 is a packaged component, then the package housing connects to the heat spreader 30 using thermal interface material 80. The semi-conductor die within the component 70 will typically be thermally connected to the package housing via thermal conducting material within the package. If the component 70 is a lidless component, then the semi-conductor die may be directly thermally connected to the heat spreader 30 via thermal interface material 80.

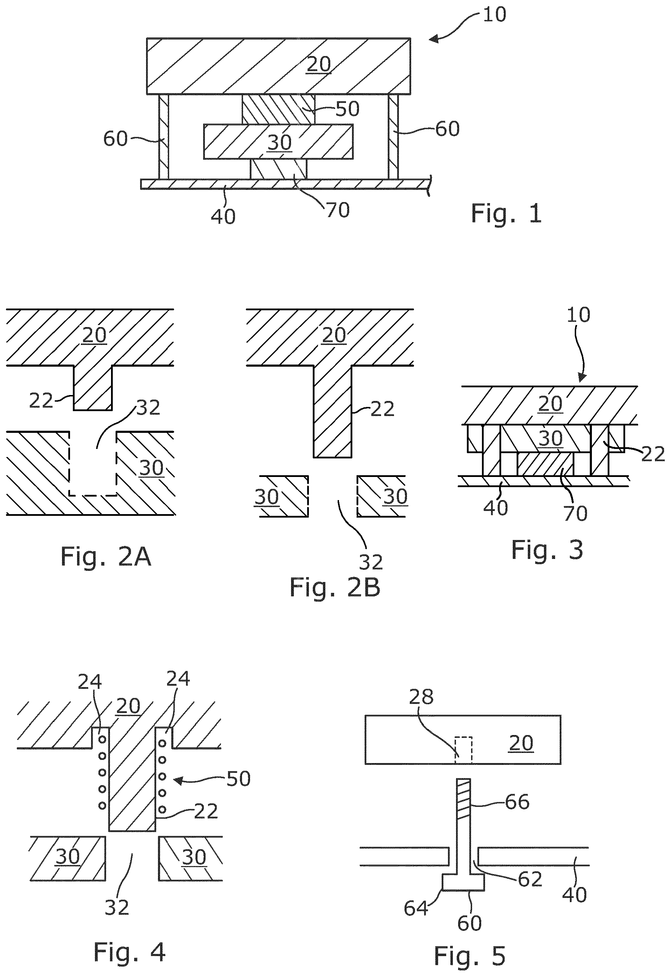

Fig. 1 illustrates an example of the apparatus 10. In this example, the printed wiring board 40 comprises one or more components 70 that are to be cooled. In the FIG, and in the following examples reference will be made to a single component 70. However, it should be appreciated that a single heat spreader 30 may be thermally connected to one or more components 70. Furthermore, it should be appreciated that a heat sink 20 may be coupled to one or more heat spreaders 30 via respective resilient bias means 50.

The apparatus 10 comprises a heat sink 20, a heat spreader 30, a printed wiring board 40 comprising one or more components 70, a resilient bias means 50 positioned between the heat sink 20 and the heat spreader 30 and at least one retainer 60. The at least one retainer 60 is configured to force the heat sink 20 towards the heat spreader 30 against the resilient bias means 50 and configured to force the printed wiring board 40 towards the heat spreader 30. From the reference point of the heat sink 20, the resilient bias means 50 pushes the heat spreader 30 away from the heat sink 20. The heat spreader 30, in turn, pushes the printed wiring board 40 away from the heat sink 20, via the one or more components 70 of the printed wiring board

The at least one retainer 60 is under tension and prevents the printed wiring board 40 moving away from the heat sink 20.

The at least one retainer 60 may be configured to be stiff and unyielding. It therefore defines a maximum separation between the heat sink 20 and the printed wiring board 40. However, in at least some examples, the at least one retainer 60 is fixed to the heat sink 20 but is not fixed to the printed wiring board 40 and enables relative movement of the printed wiring board 40 towards the heat sink 20. Such movement, however, is against the resilient bias means 50.

Although, in at least some examples, the at least one retainer 60 prevents the printed wiring board 40 and the heat sink 20 being separated beyond a predetermined distance, it is still possible for the position of the heat spreader 30 within that distance to vary. As previously described, it is also possible in at least some examples, for the printed wiring board 40 to move towards the heat sink 20 against the force provided by the resilient bias means 50.

It will therefore be appreciated that the apparatus 10 is configured to mitigate the effects of manufacturing tolerances and/or thermal expansion/distortion and/or vibration impacts.

Although not illustrated in Fig. 1, thermal interface material may be used to form a thermally conductive interface between the heat spreader 30 and the component 70 and, separately, between the heat spreader 30 and the heat sink 20. This is illustrated in at least some of the following figures.

As illustrated in Figs. 2A, 2B, 3 and 4 the heat sink 20 may comprise a protrusion 22 that extends at least into an aperture 32 in the heat spreader 30.

In Fig. 2A, the protrusion 22 from the heat sink 20 extends only partially into an aperture 32 in the heat spreader 30. The aperture 32 may, for example, be a blind aperture that does not pass through the heat spreader 30.

In the example of Fig. 2B, the protrusion 22 from the heat sink 20 extends through an aperture 32 in the heat spreader 30. The aperture 32 in the heat spreader 30 is a through-aperture that extends all the way through the heat spreader 30.

In the examples of Figs. 2A and 2B, the heat sink 20 and the heat spreader 30 have been separated to clearly show the protrusion 22 and aperture 32. However, in use the heat sink 20 would be adjacent to the heat spreader 30, connected thereto by thermal interface material 80 and the protrusion 22 will enter the aperture 32.

Fig. 3 illustrates an example of an apparatus 10 where the heat sink 20 comprises a protrusion 22 that extends from the heat sink 20 through a through-aperture 32 (not labelled in FIG 3) in the heat spreader 30 and abuts the printed wiring board 40. The apparatus 10 is otherwise as previously described. The apparatus 10 comprises a resilient bias means 50 (not illustrated in the Fig) positioned between the heat sink 20 and the heat spreader 30 and at least one retainer 60 (not illustrated in the Fig) configured to force the heat sink 20 towards the heat spreader 30 against the resilient bias means 50 and configured to force the printed wiring board 40 towards the heat spreader 30. The component 70 on the printed wiring board 40 may be thermally connected to the heat spreader 30 via thermal interface material 80 (not illustrated in this Fig) and the heat spreader 30 may be thermally connected to the heat sink 20 via thermal interface material 80 (not illustrated in this Fig). The abutment of the protrusions 22 of the heat sink 20 against the printed wiring board 40 prevents the movement of the printed wiring board 40 towards the heat sink 20. In other examples, the protrusions 22 of the heat sink 20 may not normally abut the printed wiring board 40 but may be separated therefrom by a small gap. In this example, the protrusion 22 limits the extent of the movement of the printed wiring board 40 towards the heat sink 20.

In the examples illustrated in Figs. 2A, 2B and 3, the protrusion 22 from the heat sink 20 has a cross-sectional area that closely matches the cross-sectional area of the aperture 32 in the heat spreader 30. That is the protrusion 22 forms a close or snug fit with the aperture 32. The protrusion 22 therefore acts as a guiding boss that correctly positions the heat sink 20 relative to the heat spreader 30.

Fig. 4 illustrates an example of the apparatus 10 and, in particular, an example of resilient bias means 50. In this example, the resilient bias means 50 is positioned by the protrusion 22. In the example illustrated, the resilient bias means 50 surrounds the protrusion 22. Fig. 4 illustrates a cross-sectional view through the heat sink 20 with protrusion 22 and the heat spreader 30 with aperture 32. In this example, the resilient bias means 50 is a helical spring that has a diameter that is slightly larger than the diameter of the protrusion 22 and also slightly greater than the diameter of the aperture 32. When the heat sink 20 and the heat spreader 30 are brought together, the protrusion 22 enters the aperture 32, and the resilient bias means 50 (the spring) is compressed and retained within the gap between the heat sink 20 and the heat spreader 30.

In the example illustrated, the heat sink 20 comprises a recessed portion 24 that receives and positions the resilient bias means 50. As the heat sink 20 and the heat spreader 30 are brought into an adjacent position the resilient bias means 50 (the spring) is compressed partially into the recessed portion 24. The recessed portion 24 is, in this example, a trough in the surface of the heat sink 20 that surrounds the protrusion 22. In this example, the protrusion 22 is cylindrical, the resilient bias means 50 is a helical spring and the aperture 32 is also cylindrical. Other suitable forms may be used.

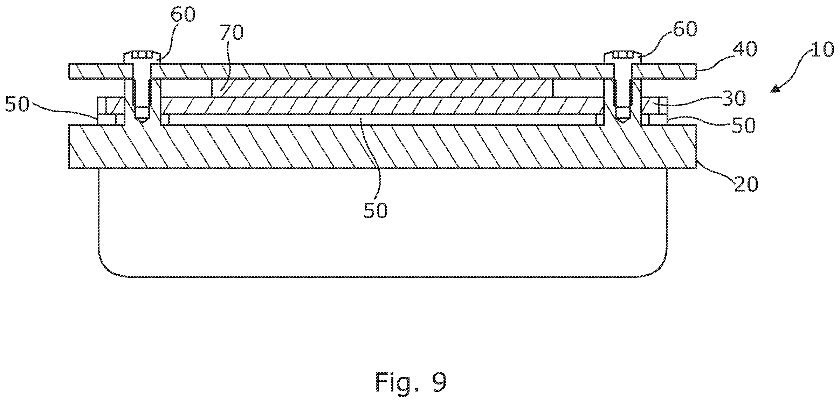

Fig. 9 illustrates an alternative example of a resilient bias means 50. The apparatus 10 uses a high-elastic thermal pad or foam as the resilient bias means 50.

As previously described, the at least one retainer 60 fixes the printed wiring board 40 to the heat sink 20, in that, it prevents the printed wiring board 40 being separated from the heat sink 20. In the example illustrated in Fig. 5, the at least one retainer 60 extends through a through-aperture 62 in the printed wiring board 40. In the example illustrated, the at least one retainer 60 is a screw that has a screw head 64 that is of a size larger than the through-aperture 62 in the printed wiring board 40. The screw 60 has a threaded portion 66 that is received by a threaded receiving portion 28 of the heat sink 20.

In some, but not necessarily all examples, the threaded receiving portion 28 of the heat sink 20 that receives the threaded portion 66 of the screw 60 is present in a protrusion 22 from the heat sink 20. Such a protrusion 22 forms a retaining boss.

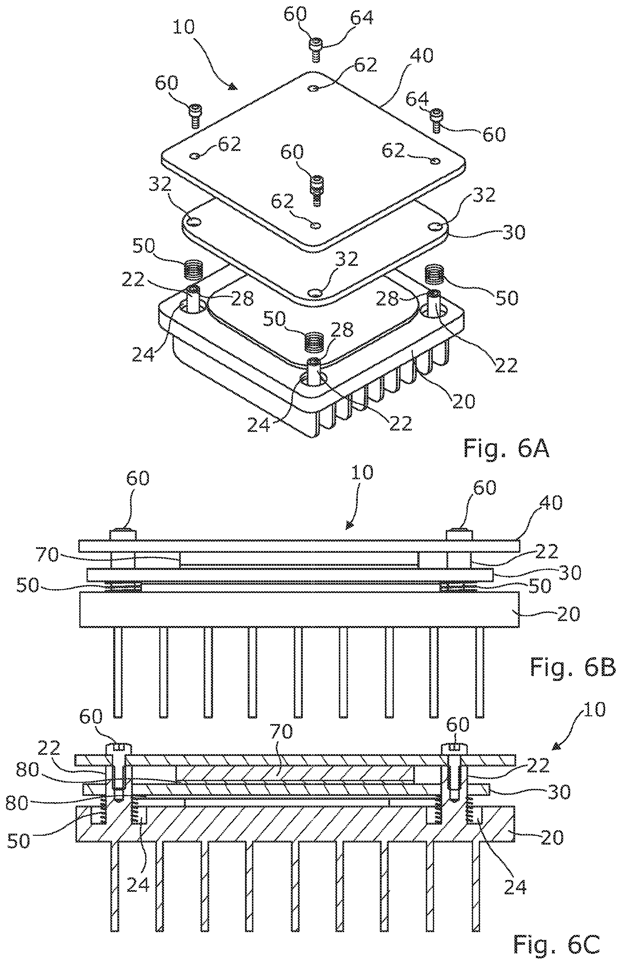

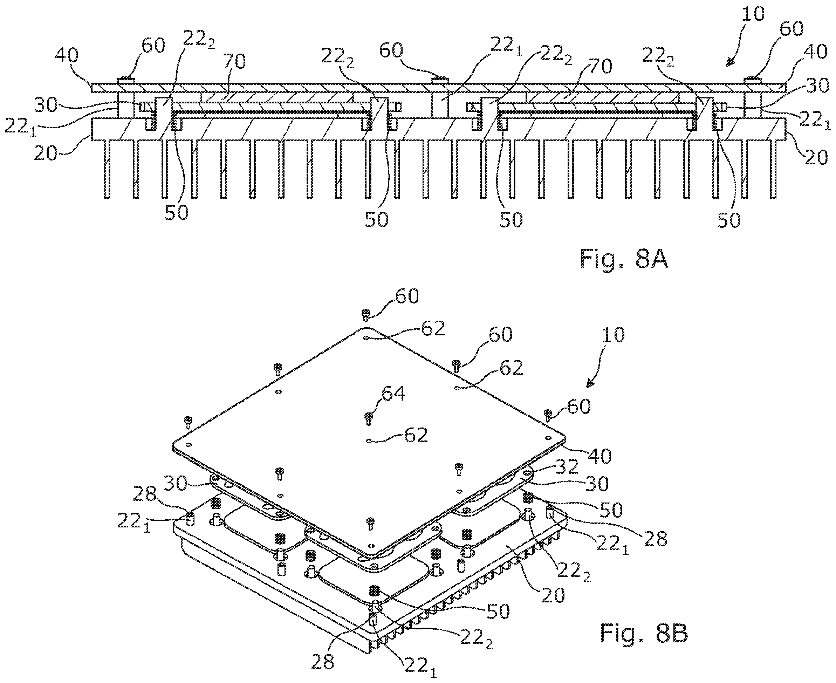

In some examples (Figs. 6A, 6B, 6C) the retaining boss and the guiding boss may be the same component 22. In other examples (Fig. 8A, 8B) the retaining boss 22₁ and the guiding boss 22₂ may be different components.

Where the same protrusion 22 is used as the guiding boss and retaining boss (Figs. 6A to 6C), the retainer 60 extends through an aperture 32 in the heat spreader 30. In the examples where the retaining boss 22₁ is different to the guiding boss 22₂, the at least one retainer 60 does not necessarily pass through an aperture 32 in the heat spreader 30.

Figs. 6A, 6B and 6C illustrate an example of the apparatus 10. Fig. 6A illustrates an exploded perspective view of the components of the apparatus 10. Fig. 6B illustrates a side view of the apparatus 10 when assembled. Fig. 6C illustrates a cross-sectional view through the apparatus 10 when assembled.

In this example illustrated from Fig 6A to 6C, the apparatus 10 comprises a heat sink 20, a heat spreader 30 connected to the heat sink 20 via thermal interface material 80; a printed wiring board 40 supporting a component 70, wherein the component 70 is thermally connected to the heat spreader 30 via thermal interface material 80. The heat sink 20 comprises protruding bosses 22 that function as guiding bosses and retaining bosses. The protrusions 22 extend through apertures 32 in the heat spreader 30 and abut the printed wiring board 40 adjacent through-apertures 62 in the printed wiring board 40. Screws 60 extend through the apertures 62 in the printed wiring board 40, through through-apertures 32 in the heat spreader 30 and into threaded receiving portions 28 of the protruding bosses 22 of the heat sink 20. The head 64 of the screw 60 is larger than the aperture 62 in the printed wiring board 40.

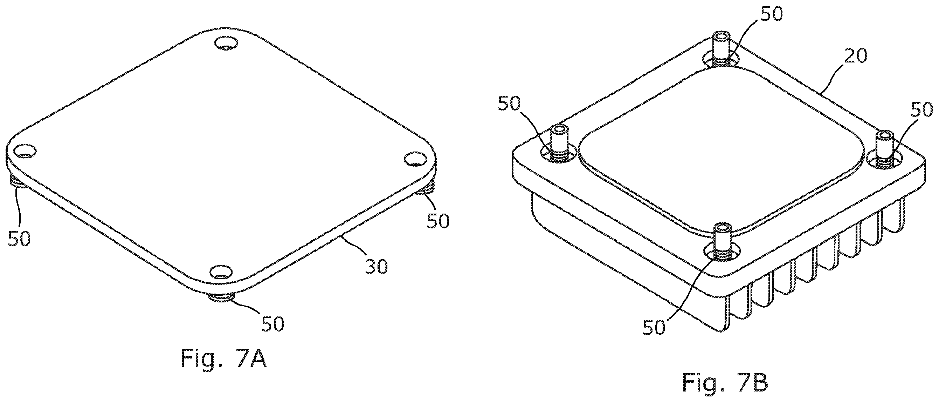

The protruding bosses 22 of the heat sink 20 have surrounding recessed portions 24 that partially receive a resilient bias means 50. In this example, the resilient bias means 50 is a helical spring. The resilient bias means is compressed in a position between the heat sink 20 and the heat spreader 30. The screws 60 force the heat sink 20 and the heat spreader 30 together against the springs 50 and force the printed wiring board 40 and the heat spreader 30 together. In some examples, the springs 50 may be attached to the heat spreader 30 in positions that overlap the apertures 32 in the heat spreader 30, as illustrated in Fig. 7A. In other examples, the springs 50 may be connected to the heat sink 20, for example, within the recessed portions 24 of the heat sink 20, as illustrated in Fig. 7B.

Figs. 8A and 8B illustrate another example of an apparatus 10. This apparatus 10 is similar to the apparatus illustrated in Figs. 6A, 6B and 6C except that whereas in the previous example a single protruding boss 22 is used as both a guiding boss and a retaining boss, in the example of Figs. 8A and 8B different physical components are used as a guiding boss 22₁ and as a retaining protruding boss 22₂. In this example, the screws 60 therefore pass through an aperture 62 in the printed wiring board 40 into the threaded receiving portion 28 of the retaining protruding boss 22₁, without passing through an aperture 32 in the heat spreader 30.

Fig. 8A illustrates a cross-sectional side view through the apparatus 10 when assembled. Fig. 8B illustrates an exploded perspective view of the components of the apparatus 10..

In this example, the apparatus 10 comprised a heat sink 20, a heat spreader 30 connected to the heat sink 20 via thermal interface material 80; a printed wiring board 40 supporting a component 70, wherein the component 70 is thermally connected to the heat spreader 30 via thermal interface material 80 (thermal interface material 80 not shown in FIG 8B). The heat sink 20 comprises protruding guiding bosses 22₂ and protruding retaining bosses 22₁. The guiding bosses 22₂ extend through apertures 32 in the heat spreader 30. The protruding retaining bosses 22₁ abut the printed wiring board 40 adjacent through-apertures 62 in the printed wiring board 40 but do not extend through apertures 32 in the heat spreader 30. Screws 60 extend through the apertures 62 in the printed wiring board 40 and into threaded receiving portions 28 of the protruding retaining bosses 22₁ of the heat sink 20. The head 64 of the screw 60 is larger than the aperture 62 in the printed wiring board 40.

The protruding guiding bosses 22₂ of the heat sink 20 have surrounding recessed portions 24 that at least partially receive a resilient bias means 50. In this example, the resilient bias means 50 is a helical spring. The resilient bias means 50 is compressed in a position between the heat sink 20 and the heat spreader 30.

The screws 60 force the heat sink 20 towards the heat spreader 30 against the springs 50 and force the printed wiring board 40 towards the heat spreader 30. In some examples, the springs 50 may be attached to the heat spreader 30 or connected to the heat sink 20, for example, within the recessed portions 24 of the heat sink 20.

Fig. 9 illustrates an example of an apparatus 10 as previously described, in which the resilient bias means 50 is a resiliently deformable layer that is thermally conductive. The layer 50 is compressed between the heat spreader 30 and the heat sink 20. It forms a thermal bridge between the heat sink 20 and the heat spreader 30 and, in addition, provides a resilient bias force pushing the heat spreader 30 towards the component 70 and printed wiring board 40. The layer 50 provides: resilient bias means (this functions similarly to a spring) and a thermally conductive bridge (this functions similarly to thermal interface material).

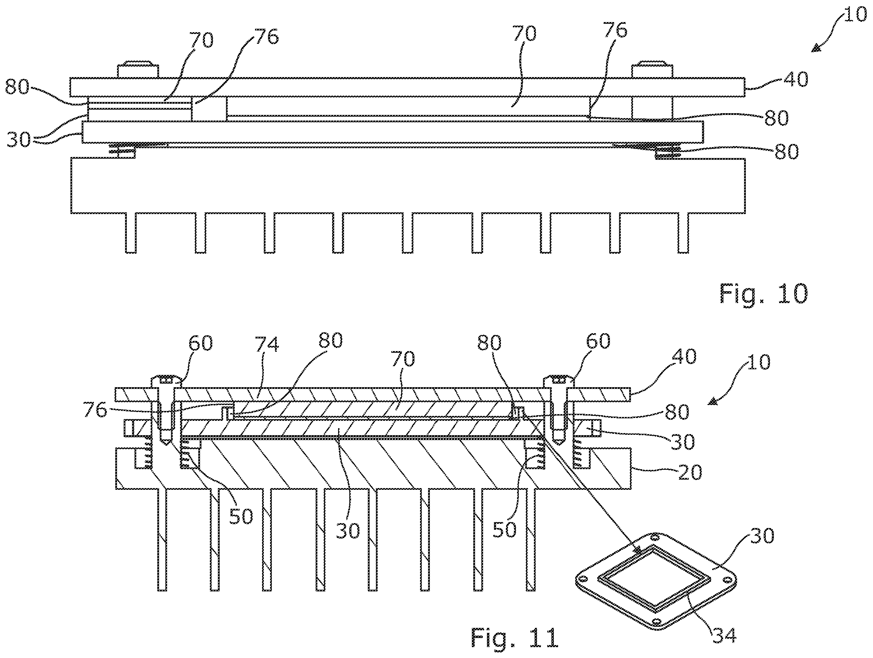

Fig. 10 illustrates an example of the apparatus 10 in which a shape of the heat spreader 30 is adjusted to conform to the shape of different components 70 on the printed wiring board 40. In this example, the printed wiring board 40 has multiple components 70. Each of the multiple components 70 contacts the heat spreader 30 via thermal interface material 80. The heat spreader 30 has a three-dimensional shape that conforms to at least height dimensions 76 of the multiple components 70. The heat spreader 30 therefore has variable relief. It has a raised profile adjacent to the thinner component 70 to the left of the Figure and has a lower profile adjacent to the thicker component 70 in the middle of the Figure.

In some examples, for example as illustrated in Fig. 11, the apparatus 10 comprises a heat spreader 30 that is configured to match lateral dimensions of the component 70.

In this example, the heat spreader 30 comprises a three-dimensional contact region 34 sized to match with lateral dimensions 74 and height dimensions 76 of the component 70. In this example, the heat spreader 30 comprises a wall portion 34 that is designed to closely circumscribe the component 70. The height of the wall 34 is, however, less than the height of the component 70. As previously, thermal interface material 80 may be used to form a thermal bridge between the heat spreader 30 and the component 70. In this example, the thermal interface material 80 may extend over the whole of the three-dimensional contact region 34, including the inside portions of the walls 34.

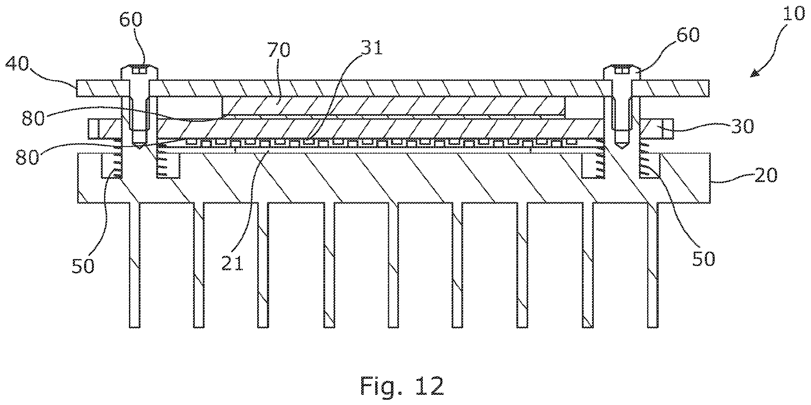

As illustrated in Fig. 12, the apparatus 10 may additionally comprise physical features 21, 31 that are designed to improve the thermal conductivity within the stack of elements/components 20, 30, 70. In this example, the surface area between the heat spreader 30 and the heat sink 20 may be significantly increased by the use of surface features 21 on the heat sink 20 that correspond with surface features 31 on the heat spreader 30 where they are adjacent. In the example illustrated, the heat spreader 30 comprises a series of parallel ribs 31 and the heat sink 20 comprises a corresponding series of parallel ribs 21. The ribs 31, 21 are configured to interdigitate and form a close-fitting network with a high contact surface area. The gaps between the ribs 21, 31, is filled with thermal interface material 80. In other examples, one of the heat spreader 30 and the heat sink 20 comprises a series of parallel ribs and the other of the heat spreader 30 and the heat sink 20 comprises a corresponding series of parallel recesses that receive the ribs and form a close-fitting network with a high contact surface area. The gaps between the ribs and recesses are filled with thermal interface material 80. Thus the heat spreader 30 comprises a series of features and the heat sink 20 comprises a series of corresponding features configured to inter-couple and form a close-fitting network with a high contact surface area.

In all of the preceding examples, a thermal bridge may be made between the heat spreader 30 and the heat sink 20 and a thermal bridge may be made between the heat spreader 30 and one or more components 70 of the printed wiring board 40.

In some but not necessarily all examples a thermal bridge may be formed using thermal interface material 80. This material is preferably a material that conforms to the components that it interfaces between, readily fills gaps and has a high thermal conductivity. The thermal interface material 80 may, for example, be phase change material or thermal grease. In some, but not necessarily all examples, the thickness of the thermal interface material 80 is between 30 and 150 micrometers or 50 and 100 micrometers.

In some but not necessarily all examples, the thermal interface material 80 between the heat spreader 30 and the heat sink 20 and the thermal interface material 80 between the heat spreader 30 and one or more components 70 of the printed wiring board 40 may be different material, or may be the same material.

In some but not necessarily all examples, the thermal interface material 80 between the heat spreader 30 and the heat sink 20 is thinner than the thermal interface material 80 between the heat spreader 30 and one or more components 70 of the printed wiring board 40 may be different material. In some but not necessarily all examples, the thermal interface material 80 (TIM1) between the heat spreader 30 and the heat sink 20 has a thickness between 30 and 150 micrometers or 50 and 100 micrometers In some but not necessarily all examples, the thermal interface material 80 (TIM2) between the heat spreader 30 and one or more components 70 of the printed wiring board 40 has a thickness of 0.5mm.

The thermal interface material 80 between the heat spreader 30 and the heat sink 20 fills in gaps between the heat spreader 30 and the heat sink 20. Manufacturing tolerance and deformation are mainly absorbed by this thermal interface layer 60. The thermal interface material 80 may, for example, be a thermal gel, a thermal foam or a thermal pad.

The thermal interface material 80 between the heat spreader 30 and one or more components 70 of the printed wiring board 40 may, for example, be phase change material or thermal grease.

In some, but not necessarily all examples, the heat spreader 30 has thermal interface material 80 on a first surface adjacent to a component 70 of the printed wiring board 40 and on an opposing second surface adjacent a heat sink 20.

The apparatus described above has particular application in high heat flux density applications. It is particularly advantageous where air cooling is used. Air cooling may be forced air cooling, where an air current is created using a fan. Alternatively, air cooling may be natural or passive, where a fan is not used. It is expected that the apparatus 10 may be used in 5G telecommunication equipment

The apparatus 10 may therefore be part of a larger component, such as for example a radio frequency transceiver, a mobile terminal, a base station or access point.

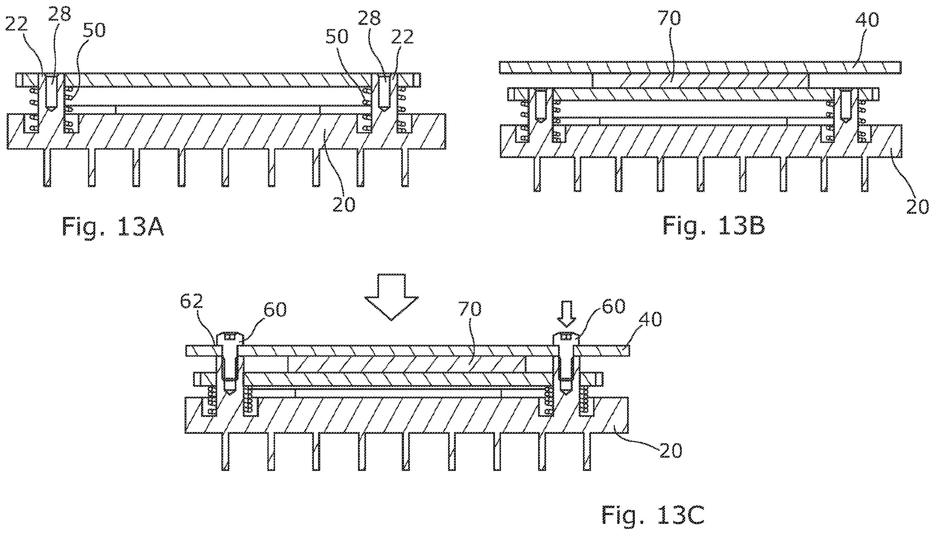

Figs. 13A, 13B and 13C illustrate an example of a method for manufacturing the apparatus 10. In Fig 13A, springs 50 are placed over the protruding guiding bosses 22 of the heat sink 20 into the retaining portions 24 (not labelled) adjacent to the protruding guiding bosses 22 of the heat sink 20. Thermal interface material 80 (not illustrated) is placed over the surface of the heat sink 20 that is on the same side as the protruding guiding bosses 22. The heat spreader 30 is positioned over the heat sink 20. The through-apertures 32 (not labelled) in the heat spreader 30 receive the protruding guiding bosses 22.

In Fig. 13B, the printed wiring board 40 comprising at least one component 70 is connected to the exposed surface of the heat spreader 30 via thermal interface material 80 (not illustrated).

As illustrated in Fig. 13C, the retainers 60 are placed through the apertures 62 in the printed wiring board 40 and enter the retaining bosses 22 (not labelled) of the heat sink 20. In this example, the same physical protrusion 22 operates as the guiding boss and the retaining boss. Tightening this screw to a threaded receiving portion 28 of the retaining boss 22 fixes the printed wiring board 40 to the heat sink 20.

Where a structural feature has been described, it may be replaced by means for performing one or more of the functions of the structural feature whether that function or those functions are explicitly or implicitly described.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one." or by using "consisting".

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of 'at least one' or 'one or more' may be used to emphasis an inclusive meaning but the absence of these terms should not be taken to infer and exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

## Claims

1. An apparatus (10) comprising:
a heat sink (20);
a heat spreader (30);
a printed wiring board (40);
a resilient bias means (50) positioned between the heat sink and the heat spreader and
at least one retainer (60) configured to force the heat sink towards the heat spreader against the resilient bias means and configured to force the printed wiring board towards the heat spreader, wherein the heat sink comprises at least one protrusion (22),
**characterised in that** the at least one protrusion extends at least into a respective aperture (32) in the heat spreader.

2. An apparatus as claimed in claim 1, wherein the at least one protrusion extends from the heat sink through the aperture in the heat spreader and abuts the printed wiring board.

3. An apparatus as claimed in claim 1 or 2 wherein the resilient bias means surrounds the protrusion.

4. An apparatus as claimed in any preceding claim, wherein the heat sink comprises a recessed portion (24) configured to receive and position the resilient bias means.

5. An apparatus as claimed in any preceding claim, wherein the resilient bias means is a spring.

6. An apparatus as claimed in any preceding claim, wherein the at least one retainer is configured to fix the printed wiring board to the heat sink.

7. An apparatus as claimed in any preceding claim, wherein the at least one retainer extends through an aperture in the heat spreader.

8. An apparatus as claimed in claim 7, wherein the retainer extends through an aperture (62) in the printed wiring board.

9. An apparatus as claimed in any preceding claim, wherein the at least one retainer is a screw.

10. An apparatus as claimed in any preceding claim, comprising at least one component (70) on the printed wiring board and comprising thermal interface material coupling the at least one component to the heat spreader and thermal interface material coupling the heat spreader to the heat sink.

11. An apparatus as claimed in claim 10, wherein the heat spreader comprises a three-dimensional contact region sized to match dimensions of the at least one component.

12. An apparatus as claimed in any preceding claim, comprising multiple components on the printed wiring board wherein each of the multiple components contacts the heat spreader via thermal interface material and wherein the heat spreader has a three-dimensional shape that conforms to at least height dimensions of the multiple components.

13. An apparatus as claimed in any preceding claim, wherein the heat sink and the heat spreader comprise inter-coupled features.

14. A Telecommunication equipment comprising an apparatus as claimed in any preceding claim.

## Patentansprüche

1. Vorrichtung (10), umfassend:
eine Wärmesenke (20);
einen Wärmeverteiler (30);
eine gedruckte Leiterplatte (40);
ein elastisches Vorspannungsmittel (50), das zwischen der Wärmesenke und dem Wärmeverteiler positioniert ist, und
mindestens ein Rückhalteelement (60), das dazu ausgestaltet ist, die Wärmesenke gegen das elastische Vorspannungsmittel hin zu dem Wärmeverteiler zu zwingen, und dazu ausgestaltet ist, die gedruckte Leiterplatte hin zu dem Wärmeverteiler zu zwingen, wobei die Wärmesenke mindestens einen Vorsprung (22) umfasst, **dadurch gekennzeichnet, dass** der mindestens eine Vorsprung sich mindestens in eine entsprechende Öffnung (32) in dem Wärmeverteiler erstreckt.

2. Vorrichtung nach Anspruch 1, wobei der mindestens eine Vorsprung sich von der Wärmesenke durch die Öffnung in dem Wärmeverteiler erstreckt und an die gedruckte Leiterplatte anstößt.

3. Vorrichtung nach Anspruch 1 oder 2, wobei das elastische Vorspannungsmittel den Vorsprung umgibt.

4. Vorrichtung nach einem der vorhergehenden Ansprüche, wobei die Wärmesenke einen vertieften Abschnitt (24) umfasst, der dazu ausgestaltet ist, das elastische Vorspannungsmittel aufzunehmen und zu positionieren.

5. Vorrichtung nach einem der vorhergehenden Ansprüche, wobei das elastische Vorspannungsmittel eine Feder ist.

6. Vorrichtung nach einem der vorhergehenden Ansprüche, wobei das mindestens eine Rückhalteelement dazu ausgestaltet ist, die gedruckte Leiterplatte an der Wärmesenke zu befestigen.

7. Vorrichtung nach einem der vorhergehenden Ansprüche, wobei das mindestens eine Rückhalteelement sich durch eine Öffnung in dem Wärmeverteiler erstreckt.

8. Vorrichtung nach Anspruch 7, wobei das Rückhalteelement sich durch eine Öffnung (62) in der gedruckten Leiterplatte erstreckt.

9. Vorrichtung nach einem der vorhergehenden Ansprüche, wobei das mindestens eine Rückhalteelement eine Schraube ist.

10. Vorrichtung nach einem der vorhergehenden Ansprüche, die mindestens eine Komponente (70) auf der gedruckten Leiterplatte umfasst und Wärmeleitmaterial, das die mindestens eine Komponente an den Wärmeverteiler koppelt, und Wärmeleitmaterial umfasst, das den Wärmeverteiler an die Wärmesenke koppelt.

11. Vorrichtung nach Anspruch 10, wobei der Wärmeverteiler eine dreidimensionale Kontaktregion umfasst, die bemessen ist, um mit Abmessungen der mindestens einen Komponente zusammenzupassen.

12. Vorrichtung nach einem der vorhergehenden Ansprüche, die mehrere Komponenten auf der gedruckten Leiterplatte umfasst, wobei jede der mehreren Komponenten den Wärmeverteiler über Wärmeleitmaterial kontaktiert und wobei der Wärmeverteiler eine dreidimensionale Form aufweist, die sich an mindestens Höhenabmessungen der mehreren Komponenten anpasst.

13. Vorrichtung nach einem der vorhergehenden Ansprüche, wobei die Wärmesenke und der Wärmeverteiler miteinander gekoppelte Merkmale umfassen.

14. Telekommunikationsausrüstung, die eine Vorrichtung nach einem der vorhergehenden Ansprüche umfasst.

## Revendications

1. Appareil (10) comprenant :
un dissipateur de chaleur (20) ;
un diffuseur de chaleur (30) ;
une carte de circuit imprimé (40) ;
un moyen de sollicitation résilient (50) positionné entre le dissipateur de chaleur et le diffuseur de chaleur, et
au moins un dispositif de retenue (60) configuré pour former le dissipateur de chaleur vers le diffuseur de chaleur contre le moyen de sollicitation résilient et configuré pour forcer la carte de circuit imprimé vers le diffuseur de chaleur, dans lequel le dissipateur de chaleur comprend au moins une saillie (22),
**caractérisé en ce que** :
la au moins une saillie s'étend au moins dans une ouverture (32) respective dans le diffuseur de chaleur.

2. Appareil selon la revendication 1, dans lequel la au moins une saillie s'étend à partir du dissipateur de chaleur en passant par l'ouverture dans le diffuseur de chaleur et vient en butée contre la carte de circuit imprimé.

3. Appareil selon la revendication 1 ou 2, dans lequel le moyen de sollicitation résilient entoure la saillie.

4. Appareil selon l'une quelconque des revendications précédentes, dans lequel le dissipateur de chaleur comprend une partie évidée (24) configurée pour recevoir et positionner le moyen de sollicitation résilient.

5. Appareil selon l'une quelconque des revendications précédentes, dans lequel le moyen de sollicitation résilient est un ressort.

6. Appareil selon l'une quelconque des revendications précédentes, dans lequel le au moins un dispositif de retenue est configuré pour fixer la carte de circuit imprimé sur le dissipateur de chaleur.

7. Appareil selon l'une quelconque des revendications précédentes, dans lequel le au moins un dissipateur de chaleur s'étend à travers une ouverture dans le diffuseur de chaleur.

8. Appareil selon la revendication 7, dans lequel le dispositif de retenue s'étend à travers une ouverture (62) dans la carte de circuit imprimé.

9. Appareil selon l'une quelconque des revendications précédentes, dans lequel le au moins un dispositif de retenue est une vis.

10. Appareil selon l'une quelconque des revendications précédentes, comprenant au moins un composant (70) sur la carte de circuit imprimé et comprenant un matériau d'interface thermique couplant le au moins un composant au diffuseur de chaleur et le matériau d'interface thermique couplant le diffuseur de chaleur au dissipateur de chaleur.

11. Appareil selon la revendication 10, dans lequel le diffuseur de chaleur comprend une région de contact tridimensionnelle dimensionnée pour correspondre aux dimensions du au moins un composant.

12. Appareil selon l'une quelconque des revendications précédentes, comprenant plusieurs composants sur la carte de circuit imprimé, dans lequel chacun de la pluralité de composants est en contact avec le diffuseur de chaleur via le matériau d'interface thermique et dans lequel le diffuseur de chaleur a une forme tridimensionnelle qui se conforme au moins aux dimensions de hauteur de la pluralité de composants.

13. Appareil selon l'une quelconque des revendications précédentes, dans lequel le dissipateur de chaleur et le diffuseur de chaleur comprennent des caractéristiques couplées entre elles.

14. Équipement de télécommunication comprenant un appareil selon l'une quelconque des revendications précédentes.
